(19) Europäisches Patentamt
European Patent Office
Office européen des brevets

(11) **EP 2 590 328 A1**

(12) **EUROPEAN PATENT APPLICATION**

(43) Date of publication:
**08.05.2013 Bulletin 2013/19**

(51) Int Cl.:
**H03L 7/08** (2006.01) **G01R 19/25** (2006.01)

(21) Application number: **11187366.7**

(22) Date of filing: **01.11.2011**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(71) Applicant: **ABB Research Ltd.**<br>**8050 Zürich (CH)**<br><br>(72) Inventors:<br> • **Ho, Ngai-Man**<br> **5442 Fislisbach (CH)** | • **Escobar, Gerardo**<br> **5405 Dättwil-Baden (CH)**<br> • **Pettersson, Sami**<br> **5430 Wettingen (CH)**<br><br>(74) Representative: **Parta, Ari Petri**<br> **Kolster Oy Ab**<br> **Iso Roobertinkatu 23**<br> **P.O. Box 148**<br> **00121 Helsinki (FI)** |

(54) **Method and arrangement for detecting frequency and fundamental wave component of three-phase signal**

(57)    A method and an arrangement for detecting a frequency of a measured three-phase voltage. The method comprises a step of measuring a three-phase voltage ($v_{\alpha\beta}$), forming a discrete model for a periodic signal, the discrete model comprising the three-phase voltage ($v_{\alpha\beta}$) and a difference ($\varphi_{\alpha\beta,k}$) between a positive voltage component and a negative voltage component of the three-phase voltage as model variables, forming a discrete detector based on the formed discrete model, detecting a fundamental wave component of the voltage ($\hat{v}_{\alpha\beta,1}$) and the difference ($\hat{\varphi}_{\alpha\beta,1}$) between the positive voltage component and the negative voltage component of the three-phase voltage from an error ($\tilde{v}_{\alpha\beta}$) between the measured voltage ($v_{\alpha\beta}$) and detected fundamental wave component of the voltage ($\hat{v}_{\alpha\beta,1}$) by using the discrete detector and a sampling time ($T_s$) together with a detected frequency ($\hat{\omega}_0$) of the measured voltage, the detected frequency ($\hat{\omega}_0$) of the measured voltage being detected from a detected difference ($\hat{\varphi}_{\alpha\beta,k}$) between positive and negative voltage components of the measured voltage and from an error ($\tilde{v}_{\alpha\beta}$) between the measured voltage ($v_{\alpha\beta}$) and the detected fundamental wave component of the voltage ($\hat{v}_{\alpha\beta,1}$) in an adaptation mechanism.

FIG 1

**Description**

FIELD OF THE INVENTION

The present invention relates to phase-locked loops, and specifically to discrete phase-locked loops used for detection of angular frequency and a fundamental wave component of a reference signal.

BACKGROUND OF THE INVENTION

Many applications require detection of fundamental angular frequency and extraction of a clean balanced three-phase sinusoidal signal, i.e. the positive sequence of a fundamental wave component. The latter can be synchronized with a three-phase reference signal, despite the presence of severe unbalance and high harmonic distortion. In particular detection of the fundamental angular frequency is needed for the synchronization of three-phase grid connected systems such as power conditioning equipment, flexible ac transmission systems (FACTS), power line conditioners, regenerative drives, uninterruptible power supplies (UPS), grid connected inverters for alternative energy sources, and other distributed generation and storage systems.

A conventional three-phase phase-locked loop (PLL) based on a synchronous reference frame (SRF-PLL) is perhaps the most extended technique used for frequency-insensitive positive-sequence detection. Different schemes have been proposed based on this conventional scheme, and most of them relay in a linearization assumption, and thus, the results can be guaranteed locally only. These schemes have an acceptable performance under ideal utility conditions, i.e. without harmonic distortion or unbalance. However, under more severe disturbances, the bandwidth of the SRF-PLL feedback loop must be reduced to reject and cancel out the effect of harmonics and unbalance on the output. However, the PLL bandwidth reduction is not an acceptable solution as its speed of response is considerably reduced as well.

Few digital PLL schemes have appeared in the literature so far. Most of them have been referred to as DPLL. In [1] a discrete PLL is presented for a single-phase synchronization application. It is a zero crossing detection method, which uses a structure similar to that of the conventional PLL, except that discrete filters are used, with additional advantages. One of the main characteristics is the possibility to adjust a sampling period according to a fundamental frequency, to allow integer multiple of sampling periods per fundamental period. It is, however, very sensitive to severe voltage disturbances.

In [2] a discrete PLL method is presented for the single phase synchronization problem. However, the authors use the approach of extending single phase signals to virtual three-phase signals represented in synchronous frame coordinates. The discrete part comes out of the application of two FIR filters, one to produce the $\alpha$ -coordinate and the other to produce then $\beta$-coordinate, i.e. its orthogonal signal. Then the rest of the scheme is very similar to the conventional SRF-PLL used for three-phase systems.

PLL based controllers are usually implemented digitally. Consequently, the PLL scheme has to be discretized by using approximate discretization rules in most cases. This approach may work properly for a high sampling frequency; however, it may lead to inaccuracies in cases of a relatively low sampling frequency.

BRIEF DESCRIPTION OF THE INVENTION

An object of the present invention is to provide a method and an arrangement for implementing the method so as to solve the above-described problem. The objects of the invention are achieved by a method and an arrangement which are characterized by what is stated in the independent claims. Preferred embodiments of the invention are disclosed in the dependent claims.

The present invention is of special relevance in cases where digital implementation of an overall synchronization method uses a low sampling frequency. In such a case, the present method provides a more accurate and faster response than the simple discretization of conventional continuous time based methods using approximate discretization rules.

This disclosure presents a discrete PLL system, referred to as dPLL-UH, which provides detection of an angular frequency, and additionally both the positive and negative sequences of a fundamental wave component of an unbalanced and distorted three-phase signal.

The main characteristics of the proposed dPLL-UH scheme can be listed as follows:

(i) The present dPLL-UH method includes a harmonic compensation mechanism to deal with the harmonic distortion present in a reference signal. It does not require transformation of variables into synchronous reference frame coordinates, as is the case in most PLL schemes. Moreover, the synchronization process is based on detection of a fundamental frequency.

(ii) The design of the dPLL-UH is based on a more complete and generic discrete model description of an unbalanced three-phase reference periodic signal, which can be distorted by unbalanced low order harmonics.

(iii) The dPLL-UH method provides accurate responses in cases of a low sampling frequency. This is in contrast to discretization of continuous based PLL using simple approximate discretization rules, which may lead to considerable errors.

Therefore, the dPLL-UH performs properly in cases of a relatively low sampling frequency, for reference signals showing unbalanced conditions, sags, swells, and angular frequency variations, for instance. Moreover, as the method is provided with an explicit discrete harmonic compensation mechanism (dCM-UH), it is able to reduce the effects of low-harmonics distortion without compromising the speed of response, thus providing a fast and precise response.

BRIEF DESCRIPTION OF THE DRAWINGS

In the following, the invention will be described in greater detail by means of preferred embodiments and with reference to the accompanying drawings, in which

Figure 1 shows a block diagram of a dPLL-UH method including a discrete harmonic compensation mechanism dCM-UH for an unbalanced and distorted reference signal $V_{\alpha\beta}$ ;
Figure 2 shows a block diagram of a discrete unbalanced harmonic compensation mechanism dCM-UH including unbalanced harmonic oscillators tuned at 3rd, 5th, and k-th harmonic;
Figure 3 shows comparisons between transient responses during start up of a detected fundamental frequency $\hat{\omega}_0$ rad/s);
Figure 4 shows transient responses, changing from balanced to unbalanced operation, of the detected fundamental frequency $\hat{\omega}_0$ ;
Figure 5 shows transient responses, changing from balanced to unbalanced operation, of the detected fundamental frequency $\hat{\omega}_0$ ;
Figure 6 shows a transient response of the proposed dPLL-UH when a reference signal changes from a balanced to an unbalanced condition;
Figure 7 shows a transient response of the proposed dPLL-UH when harmonic distortion is added to the already unbalanced reference signal;
Figure 8 shows a transient response of the detected fundamental frequency $\hat{\omega}_0$ (rad/s) when harmonic distortion is added to the reference signal;
Figure 9 shows a transient response of the proposed dPLL-UH to a distorted unbalanced reference signal when a utility frequency changes from 50 Hz to 35 Hz; and
Figure 10 shows a steady state response of a detected positive-sequence of a fundamental wave component.

DETAILED DESCRIPTION OF THE INVENTION

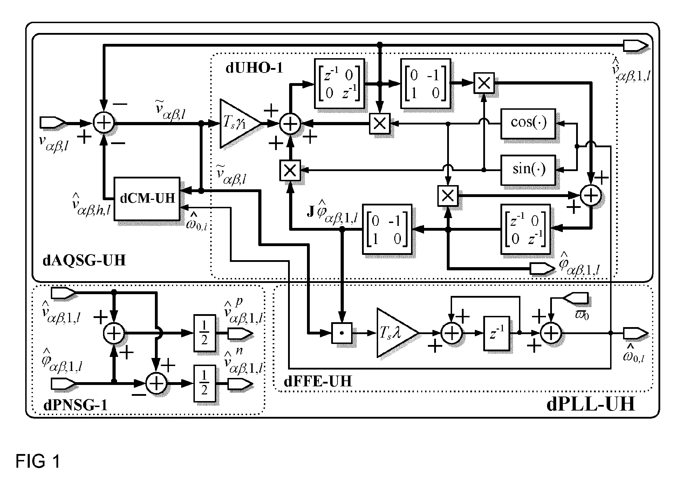

The present method has the purpose of delivering detected values for positive and negative sequences of a measured reference signal $v_{\alpha\beta}$ , as well as a detected value of the fundamental frequency $\omega_o$ .The present scheme is a discrete PLL method referred to as dPLL-UH as it appropriately handles the operation under unbalanced and harmonic distortion. The method is of special interest in cases of a low sampling frequency, where the discretization of continuous time PLL schemes, by means of approximate discretization rules, may fail to achieve the correct detected values. The dPLL-UH is composed of a discrete detector for the fundamental wave component of the measured reference signal (dAQSG-UH), a generator of the positive and negative sequences (dPNSG), and a discrete detector for the fundamental frequency (dFFE-UH). To cope with the harmonic distortion present in the reference signal, an embodiment also includes a discrete harmonic compensation mechanism (dCM-UH). A schematic of the proposed dPLL-UH comprising all elements is depicted in Figure 1. In this diagram, thick lines represent vector variables, while normal lines represent scalar variables. The design of discrete estimators dAQSG-UH, dFFE-UH, and dCM-UH is based on a quite general discrete model for a three-phase signal, which will be described next for ease of reference.

**Discrete model of a three-phase unbalanced distorted signal**

First, a model to describe a three-phase unbalanced periodic signal $v_{\alpha\beta}$ is formed. This model assumes that the signal $v_{\alpha\beta}$ is composed of a fundamental and higher order harmonics components of the fundamental frequency $\omega_0$ , having harmonic indexes in the set H = {1,3,5,...} . The model is given by

$$\dot{v}_{\alpha\beta,k} = k\omega_0 \mathbf{J} \varphi_{\alpha\beta,k} \quad , \forall k \in H$$
$$\dot{\varphi}_{\alpha\beta,k} = k\omega_0 \mathbf{J} v_{\alpha\beta,k}$$
$$v_{\alpha\beta} = \sum_{k \in H} v_{\alpha\beta,k}$$

(1)

where J is a skew symmetric matrix defined by

$$\mathbf{J} = \begin{bmatrix} 0 & -1 \\ 1 & 0 \end{bmatrix}, \mathbf{J}^T = -\mathbf{J}$$

(2)

variable $v_{\alpha\beta,k}$ is the k-th harmonic component, and $\phi_{\alpha\beta,\kappa}$ an auxiliary variable necessary for completing the model description and meaningful only in an unbalanced case. In fact, these variables can be described using symmetric components to address the unbalanced case as follows

$$v_{\alpha\beta,k} = v_{\alpha\beta,k}^{p} + v_{\alpha\beta,k}^{n} \quad , \forall k \in H$$
$$\varphi_{\alpha\beta,k} = v_{\alpha\beta,k}^{p} - v_{\alpha\beta,k}^{n}$$

(3)

where $v_{\alpha\beta,k}^{p}$ and $v_{\alpha\beta,k}^{n}$ represent the positive and negative sequence components of $v_{\alpha\beta,k}$, respectively. Thus, the auxiliary variable is the difference between the positive symmetric component and the negative symmetric component of the periodic signal in question. In particular, for the fundamental wave component we have

$$\begin{bmatrix} v_{\alpha\beta,1} \\ \varphi_{\alpha\beta,1} \end{bmatrix} = \begin{bmatrix} \mathbf{I}_2 & \mathbf{I}_2 \\ \mathbf{I}_2 & -\mathbf{I}_2 \end{bmatrix} \begin{bmatrix} v_{\alpha\beta,1}^{p} \\ v_{\alpha\beta,1}^{n} \end{bmatrix}$$

(4)

where $\mathbf{I}_2$ is the 2 x 2 identity matrix. Notice that the positive and negative sequences can be recuperated out of (4).
Exact discretization of the k-th harmonic component model (1) using the state space transformation method based on the exponential matrix yields

$$\begin{bmatrix} v_{\alpha\beta,k,\ell+1} \\ \varphi_{\alpha\beta,k,\ell+1} \end{bmatrix} = \mathbf{e}^{\mathbf{A}(k\omega_0 T_s)} \begin{bmatrix} v_{\alpha\beta,k,\ell} \\ \varphi_{\alpha\beta,k,\ell} \end{bmatrix} \quad , \forall k \in H$$

(5)

where $T_s$ represents the sampling *time,* $x_l$ is the l-th sample of variable x , and matrix $\mathbf{e}^{\mathbf{A}(k\omega_0 T_s)}$ is given by

$$\mathbf{e}^{\mathbf{A}(k\omega_0 T_s)} = \begin{bmatrix} \cos(k\omega_0 T_s) & 0 & 0 & -\sin(k\omega_0 T_s) \\ 0 & \cos(k\omega_0 T_s) & \sin(k\omega_0 T_s) & 0 \\ 0 & -\sin(k\omega_0 T_s) & \cos(k\omega_0 T_s) & 0 \\ \sin(k\omega_0 T_s) & 0 & 0 & \cos(k\omega_0 T_s) \end{bmatrix}. \quad (6)$$

At this point it is important to distinguish between l and k . Notice that l is used to address the l-th sample in the discrete representation, while $k$ is used to address the $k$ -th harmonic component.

Model (5) can also be written, using the skew-symmetric matrix J , as follows

$$v_{\alpha\beta,k,\ell+1} = \cos(k\omega_0 T_s) v_{\alpha\beta,k,\ell} + \mathbf{J}\sin(k\omega_0 T_s)\varphi_{\alpha\beta,k,\ell}$$
$$\varphi_{\alpha\beta,k,\ell+1} = \mathbf{J}\sin(k\omega_0 T_s) v_{\alpha\beta,k,\ell} + \cos(k\omega_0 T_s)\varphi_{\alpha\beta,k,\ell} \quad , \quad (7)$$

wherefrom the $\ell$-th sample of signal $v_{\alpha\beta}$ can be reconstructed as

$$v_{\alpha\beta,\ell} = \sum_{k\in H} v_{\alpha\beta,k,\ell} \ . \quad (8)$$

Similar to (3), we can describe the discrete variables $V_{\alpha\beta}$,k,l and $\varphi_{\alpha\beta,k,\ell}$ in terms of their symmetric components as follows

$$v_{\alpha\beta,k,\ell} = v^p_{\alpha\beta,k,\ell} + v^n_{\alpha\beta,k,\ell} \quad , \forall k \in H$$
$$\varphi_{\alpha\beta,k,\ell} = v^p_{\alpha\beta,k,\ell} - v^n_{\alpha\beta,k,\ell} \quad . \quad (9)$$

Notice that positive and negative sequences can be recuperated out of (9).

It is to be noted that in a balanced case $v^n_{\alpha\beta,k,\ell} = 0$, $v_{\alpha\beta,k,\ell} = \varphi_{\alpha\beta,k,\ell}$, $\forall k \in H$ . $\forall k \in H$. Therefore, in the balanced case the discrete model (7) can be reduced to

$$v_{\alpha\beta,k,\ell+1} = \cos(k\omega_0 T_s) v_{\alpha\beta,k,\ell} + \mathbf{J}\sin(k\omega_0 T_s) v_{\alpha\beta,k,\ell}. \quad (10)$$

**Discrete detector of the fundamental wave component-dAQSG-UH**

Based on model (7) to (8), the following discrete detector is constructed for the $k$-th ($k \in H$) harmonic component of the reference signal $v_{\alpha\beta,l}$ which consists of a copy of the system model (7) to which a damping term is added, that is,

$$\hat{v}_{\alpha\beta,k,\ell+1} = \cos\left(k\hat{\omega}_{0,\ell}T_s\right)\hat{v}_{\alpha\beta,k,\ell} + \mathbf{J}\sin\left(k\hat{\omega}_{0,\ell}T_s\right)\hat{\varphi}_{\alpha\beta,k,\ell} + T_s\gamma_k\tilde{v}_{\alpha\beta,\ell} \quad, \forall k \in H$$

$$\hat{\varphi}_{\alpha\beta,k,\ell+1} = \mathbf{J}\sin\left(k\hat{\omega}_{0,\ell}T_s\right)\hat{v}_{\alpha\beta,k,\ell} + \cos\left(k\hat{\omega}_{0,\ell}T_s\right)\hat{\varphi}_{\alpha\beta,k,\ell} \tag{11}$$

$$\hat{v}_{\alpha\beta,\ell} = \sum_{k\in H}\hat{v}_{\alpha\beta,k,\ell}$$

where $\gamma_k$ $(k \in H)$ are positive design parameters used to introduce the required damping; $\hat{\omega}_{0,\ell}$ is the detected value of the $\ell$-th sample of the fundamental frequency $\omega_{0,\ell}$; $\hat{v}_{\alpha\beta,k,\ell}$ and $\hat{\varphi}_{\alpha\beta,k,\ell}$ are the detected values of $v_{\alpha\beta,k,\ell}$ and $\varphi_{\alpha\beta,k,\ell}$, respectively; we have now defined the error $\tilde{v}_{\alpha\beta,\ell} = v_{\alpha\beta,\ell} - \hat{v}_{\alpha\beta,\ell}$, with $v_{\alpha\beta,\ell}$ representing the overall detected signal. In fact, the detected signal $v_{\alpha\beta,\ell}$ can be decomposed as follows

$$\hat{v}_{\alpha\beta,\ell} = \hat{v}_{\alpha\beta,1,\ell} + \hat{v}_{\alpha\beta,h,\ell} \tag{12}$$

where $v_{\alpha\beta,1,\ell}$ represents the detected value of the fundamental wave component $v_{\alpha\beta1,,\ell}$ and $v_{\alpha\beta,h,\ell}$ represents a detected value of the harmonic distortion of the measured signal, i.e. the sum of all higher order harmonics.

In particular, the fundamental wave component $v_{\alpha\beta,1,\ell}$ can be reconstructed, based on (11), according to

$$\hat{v}_{\alpha\beta,1,\ell+1} = \cos\left(\hat{\omega}_0 T\right)\hat{v}_{\alpha\beta,1,\ell} + \mathbf{J}\sin\left(\hat{\omega}_0 T\right)\hat{\varphi}_{\alpha\beta,1,\ell} + T\gamma_1\tilde{v}_{\alpha\beta,\ell}$$

$$\hat{\varphi}_{\alpha\beta,1,\ell+1} = \mathbf{J}\sin\left(\hat{\omega}_0 T\right)\hat{v}_{\alpha\beta,1,\ell} + \cos\left(\hat{\omega}_0 T\right)\hat{\varphi}_{\alpha\beta,1,\ell} \tag{13}$$

The fundamental wave components $v_{\alpha\beta,1,\ell}$ and $\hat{\omega}_{\alpha\beta,1,\ell}$, obtained from this discrete detector, are vectors, each formed by two signals in quadrature. Therefore, detector (13) is referred to as the discrete detector of the fundamental wave component for unbalanced operation conditions and harmonic distortion (dAQSG-UH). Figure 1 shows that the dAQSG-UH is composed by a basic block referred to as the discrete unbalanced harmonic oscillator tuned at the fundamental frequency (dUHO-1), plus a feedback path.

In the balanced case, the detector for the fundamental wave component can be reduced to

$$\hat{v}_{\alpha\beta,1,\ell+1} = \cos\left(\hat{\omega}_0 T_s\right)\hat{v}_{\alpha\beta,1,\ell} + \mathbf{J}\sin\left(\hat{\omega}_0 T_s\right)\hat{v}_{\alpha\beta,1,\ell} + T_s\gamma_1\tilde{v}_{\alpha\beta,\ell}$$

$$\tilde{v}_{\alpha\beta,\ell} = v_{\alpha\beta,\ell} - \hat{v}_{\alpha\beta,\ell} \tag{14}$$

$$\hat{v}_{\alpha\beta,\ell} = \hat{v}_{\alpha\beta,1,\ell} + \hat{v}_{\alpha\beta,h,\ell}$$

where $v_{\alpha\beta,h,\ell}$ has to be redefined for the balanced case as will be shown in (17).

**Positive and negative sequences generator— dPNSG-1**

Based on relationship (9), the positive and negative sequences of the fundamental wave component of the reference signal can be reconstructed according to

$$\hat{v}^p_{\alpha\beta,1,\ell} = \frac{1}{2}\left(\hat{v}_{\alpha\beta,1,\ell} + \hat{\varphi}_{\alpha\beta,1,\ell}\right)$$

$$\hat{v}^n_{\alpha\beta,1,\ell} = \frac{1}{2}\left(\hat{v}_{\alpha\beta,1,\ell} - \hat{\varphi}_{\alpha\beta,1,\ell}\right) \tag{15}$$

where detected values $v_{\alpha\beta,1,\ell}$ and $\hat{\omega}_{\alpha\beta,1,\ell}$ are obtained as shown in the dAQSG-UH (13).

Scheme (15) is referred to as a generator of positive and negative sequences of the fundamental wave component (dPNSG-1 ). In particular, the positive sequence component $\hat{v}^{p}_{\alpha\beta,1,\ell}$ is a pure sinusoidal balanced signal, which is in phase with the reference signal $v_{\alpha\beta,\ell}$. This signal can now be used as a synchronization signal, to design a cleaner current reference, or as a transformation basis to represent variables in the synchronous frame.

### Discrete harmonic compensation mechanism - dCM-UH

This mechanism, referred to as dCM-UH, has the purpose of detecting a harmonic distortion part of the reference signal, i.e. $\hat{v}_{\alpha\beta,h,\ell}$. For harmonic rejection purposes, this signal is later subtracted from the original signal as shown in the scheme of Figure 1. Moreover, the dCM-UH block can be seen as an optional plug-in block, in the sense that it can be eliminated in the case of negligible harmonic distortion, leading to a considerably simpler scheme.

The design of this detector is based on (11) as shown below

$$\hat{v}_{\alpha\beta,k,\ell+1} = \cos\left(k\hat{\omega}_0 T_s\right)\hat{v}_{\alpha\beta,k,\ell} + \mathbf{J}\sin\left(k\hat{\omega}_0 T_s\right)\hat{\phi}_{\alpha\beta,k,\ell} + T_s\gamma_k\tilde{v}_{\alpha\beta,\ell} \quad , \forall k \in \{3,5,\ldots\}$$

$$\hat{\phi}_{\alpha\beta,k,\ell+1} = \mathbf{J}\sin\left(k\hat{\omega}_0 T_s\right)\hat{v}_{\alpha\beta,k,\ell} + \cos\left(k\hat{\omega}_0 T_s\right)\hat{\phi}_{\alpha\beta,k,\ell} \qquad (16)$$

$$\hat{v}_{\alpha\beta,h,\ell} = \sum_{k\in\{3,5,\ldots\}} \hat{v}_{\alpha\beta,k,\ell}$$

where $\gamma_k$ $(k \in \{3,5,\ldots\})$ are positive design parameters, and $J = -J^T$ is the skew symmetric matrix defined above. That is, each harmonic component $\hat{v}_{\alpha\beta,k,\ell}$ $(k \in \{3,5,\ldots\})$ is detected according to (16), which are then accumulated in a single signal $\hat{v}_{\alpha\beta,k,\ell}$.

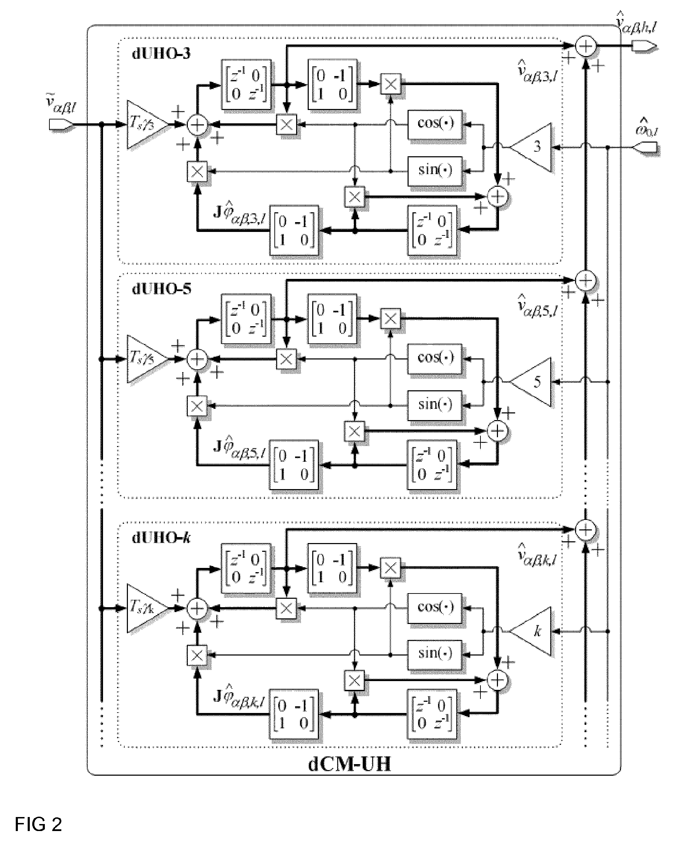

A block diagram of the dCM-UH given by (16) is presented in Figure 2. Notice that the dCM-UH is composed of a bank of basic blocks referred to as discrete unbalanced harmonic oscillators, each of them being tuned at the $k$-th harmonic under concern (dUHO-$k$).

For the balanced case, the harmonics compensation mechanism, i.e. the detection of the harmonic part of the reference signal, is reduced to

$$\hat{v}_{\alpha\beta,k,\ell+1} = \cos\left(k\hat{\omega}_0 T_s\right)\hat{v}_{\alpha\beta,k,\ell} + \mathbf{J}\sin\left(k\hat{\omega}_0 T_s\right)\hat{v}_{\alpha\beta,k,\ell} + T_s\gamma_k\tilde{v}_{\alpha\beta,\ell} \quad , \forall k \in \{3,5,\ldots\}$$

$$\hat{v}_{\alpha\beta,h,\ell} = \sum_{k\in\{3,5,\ldots\}} \hat{v}_{\alpha\beta,k,\ell} \qquad . (17)$$

The dCM-UH can be used or not, depending on the level of harmonic distortion present in the reference signal. If the dCM-UH is not used, the basic scheme, referred to as dPLL-U, still has certain robustness against harmonic distortion present in the measured reference signal owing to its selective nature. In this case, harmonic distortion rejection can be improved at the cost of limiting the bandwidth of the overall scheme, which reduces the speed of response and thus deteriorates the dynamical performance of the overall PLL scheme.

### Discrete fundamental frequency detector — dFFE-UH

Reconstruction of variable $\hat{\omega}_{0,\ell}$ involved in the dAQSG-UH (13) and in the dCM-UH (16) is performed by the following discrete fundamental frequency detector

$$\tilde{\omega}_{0,\ell+1} = \tilde{\omega}_{0,\ell} + T_s\lambda\hat{v}^T_{\alpha\beta,\ell}\mathbf{J}\hat{\phi}_{\alpha\beta,1,\ell}$$

$$\hat{\omega}_{0,\ell} = \tilde{\omega}_{0,\ell} + \varpi_0 \qquad (18)$$

where $\lambda > 0$ is a design parameter representing the adaptation gain, and $\varpi_0$ represents a nominal value of the fundamental frequency and is included in the dFFE-UH as a feedforward term to prevent high transients during the startup operation. This estimator is referred to as a discrete fundamental frequency detector for unbalanced operation and distorted conditions (dFFE-UH).

The discrete fundamental frequency detector in the balanced case is reduced to

$$\tilde{\omega}_{0,\ell+1} = \tilde{\omega}_{0,\ell} + T_s \lambda \tilde{\mathbf{v}}_{\alpha\beta,\ell}^T \mathbf{J} \hat{\mathbf{v}}_{\alpha\beta,1,\ell}$$
$$\hat{\omega}_{0,\ell} = \tilde{\omega}_{0,\ell} + \varpi_0$$ 
(19)

**Tuning of the dPLL-UH method**

For the tuning of $\lambda$ and $\gamma_1$, it is recommended to follow the following tuning rules

$$\gamma_1 = \frac{9}{\tau_s}$$
$$\lambda = \left( \frac{4.5}{\tau_s |\mathbf{v}_{\alpha\beta}|} \right)^2$$
(20)

where $\tau_s$ represents the desired settling time, which is somehow related to the desired bandwidth of the overall scheme. These tuning rules may give a first approximation, and a refinement process must be followed.

For gains $\gamma_k$ ($k \in \{3,5,...\}$) the following rules are proposed

$$\gamma_k = \frac{2.2}{\tau_{s,k}}, \left( k \in \{3,5,...\} \right)$$
(21)

where $\tau_{s,k}$ represents the desired settling time for the envelope of the $k$-th harmonic component. In this case, it is assumed that the dUHO-$k$ only influences the corresponding k-th harmonic, and that the dynamics of the simplified system (not including the dCM-UH) is, as mentioned above, a stable second order system. The influence of the simplified system is thus neglected, and each dUHOs can be tuned separately. As above, we have affected each $\gamma_k$ ($k \in \{3,5,...\}$) by the sampling time $T_s$.

**Compensation of the implementation delay**

As the delivered signal $\hat{\mathbf{v}}_{\alpha\beta,1,\ell}^p$ out of the dPLL-UH is a balanced sinusoidal signal, it may be represented as

$$\hat{\mathbf{v}}_{\alpha\beta,1,\ell}^p = \mathbf{e}^{\mathbf{J}\hat{\omega}_0 \ell T_s} \hat{V}_{dq,\ell}$$
(22)

where $\mathbf{e}^{\mathbf{J}\hat{\omega}_0 \ell T_s} = \begin{bmatrix} \cos(\hat{\omega}_0 \ell T_s) & -\sin(\hat{\omega}_0 \ell T_s) \\ \sin(\hat{\omega}_0 \ell T_s) & \cos(\hat{\omega}_0 \ell T_s) \end{bmatrix}$ is a rotation matrix, and $\hat{V}_{dq,\ell} = \begin{bmatrix} \hat{V}_{d,\ell} \\ \hat{V}_{q,\ell} \end{bmatrix}$

is the phasor of $\hat{\mathbf{v}}_{\alpha\beta,1,\ell}^p$ at the $\ell$-th sampling instant, with $\hat{V}_{d,\ell}$ as real and $\hat{V}_{q,\ell}$ as imaginary components, which are assumed to be constants.

Due to the digital implementation, the delivered signal $\hat{V}^{p}_{\alpha\beta,1,\ell}$ will exhibit an inherent delay of one sample time $T_s$. Therefore, a more realistic representation for such a signal would be

$$\overline{\hat{v}}^{p}_{\alpha\beta,1,\ell} = \mathbf{e}^{\mathbf{J}\hat{\omega}_0(\ell-1)T_s}\hat{V}_{dq,\ell} \qquad (23)$$

where the bar notation is used to refer to the delayed signal.

Notice that, using the properties of the rotation $\mathbf{e}^{\mathbf{J}\hat{\omega}_0(\ell-1)T_s}$ this can also be expressed as

$$\overline{\hat{v}}^{p}_{\alpha\beta,1,\ell} = \mathbf{e}^{-\mathbf{J}\hat{\omega}_0 T_s}\mathbf{e}^{\mathbf{J}\hat{\omega}_0\ell T_s}\hat{V}_{dq,\ell} = \mathbf{e}^{-\mathbf{J}\hat{\omega}_0 T_s}\hat{v}^{p}_{\alpha\beta,1,\ell}. \qquad (24)$$

Thus, to compensate for the delay, and thus to recuperate the nondelayed signal $\hat{V}^{p}_{\alpha\beta,1,\ell}$, it is enough to rotate the delayed signal $\overline{\hat{v}}^{p}_{\alpha\beta,1,\ell}$ counterwise as follows

$$\hat{v}^{p}_{\alpha\beta,1,\ell} = \mathbf{e}^{\mathbf{J}\hat{\omega}_0 T_s}\overline{\hat{v}}^{p}_{\alpha\beta,1,\ell} \qquad (25)$$

where the rotation matrix $\mathbf{e}^{\mathbf{J}\hat{\omega}_0 T_s}$ is given by

$$\mathbf{e}^{\mathbf{J}\hat{\omega}_0 T_s} = \begin{bmatrix} \cos(\hat{\omega}_0 T_s) & -\sin(\hat{\omega}_0 T_s) \\ \sin(\hat{\omega}_0 T_s) & \cos(\hat{\omega}_0 T_s) \end{bmatrix}. \qquad (26)$$

Notice that for an arbitrarily small $T_s$ this matrix converges towards the 2 x 2 identity matrix $I_2$, thus yielding no compensation effect.

### Numerical results

For the numerical results, the following parameters have been selected $\lambda = 1.1$ and $\gamma_1 = 400$, which approximately correspond to a settling time of $\tau_s = 0.025$ s. It is assumed that the reference signal also contains 3rd and 5th harmonics, and thus the dCM-UH contains dUHO-3 and dUHO-5 tuned at these harmonics.

The gains in the dCM-UH are fixed to $\gamma_3 = \gamma_5 = 100$, which correspond to the settling time of $\tau_{S,3} = \tau_{s,5} = 22$ ms for both UHOs. The reference signal has a nominal frequency of $\tilde{\omega} = 314.16$ rad/s (50 Hz), and an approximate amplitude of $|v_{\alpha\beta}| = 100$ V. Unless otherwise stated, a sampling time of 250 µs is considered, which corresponds to a sampling frequency of 4 kHz. The following test cases have been considered for the reference signal $v_{\alpha\beta}$.

(i) Balanced condition. The reference signal is formed only by a positive sequence of 100 V of amplitude, and fundamental frequency of 314.16 rad/s (50 Hz), with a zero phase shift.

(ii) Unbalanced condition. The reference signal includes both a positive and a negative sequence component. The positive sequence has 100 V of amplitude at 314.16 rad/s (50 Hz) and a zero phase shift. For the negative sequence, an amplitude of 30 V and a zero phase shift are considered.

(iii) Harmonic distortion. Harmonics 3rd and 5th are added to the previous unbalanced signal to create a periodic distortion. Both harmonics also have a negative sequence component to allow unbalance in harmonics as well.

(iv) Frequency variations. A step change is introduced in the fundamental frequency of the reference signal, changing from 314.16 rad/s (50 Hz) to 219.9 rad/s (35 Hz).

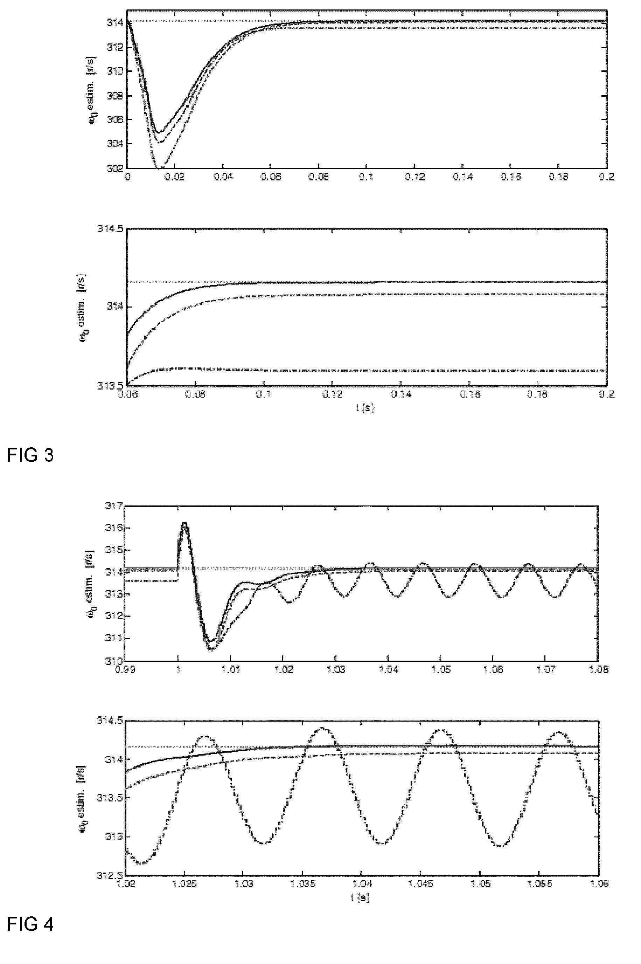

Figure 3 shows transient responses during start up of a detected fundamental frequency using the proposed dPLL-UH and a discretized UH-PLL. The UH-PLL has been discretized by using a Euler's backward (rectangular) approximation. Moreover, the implementation of the discrete UH-PLL has been modified in such a way to use, whenever possible, the latest updated intermediate available terms to evaluate the discretized expressions. This yields better results than using the one step delayed values exclusively to evaluate expressions, as formally marked by theory, where bigger errors appear and also oscillations may be observed due to unbalance as observed in Figure 3. However, even with this improved discretization of UH-PLL, it is shown that it cannot reach the reference value of the fundamental frequency. Notice in Figure 3 that this method (in dashed line) stabilizes in 314.08 rad/s, while the regular discretization (in dash-dotted line) stabilizes at 313.595. In contrast, the proposed dPLL-UH (in solid line) reaches the correct value of the reference frequency $\omega_0$ = 314.16 rad/s after a relatively short transient. The sampling frequency is fixed to 4 kHz. The lower plot of Figure 3 shows a zoom of the upper plot.

Figure 4 shows a transient response of a detected frequency during a change from a balanced to an unbalanced condition. Notice that the steady state error in the response of the improved discretization of UH-PLL remains the same after a short transient. However, the response of the regular discretization now exhibits some oscillations. Figure 4 shows in solid line the proposed dPLL-UH, in dash-dot line regular discretization of UH-PLL using Euler's backward rule, and in dashed line improved discretization of UH-PLL. A zoom of the upper plot is shown in the lower plot. The sampling frequency is fixed to 4 kHz.

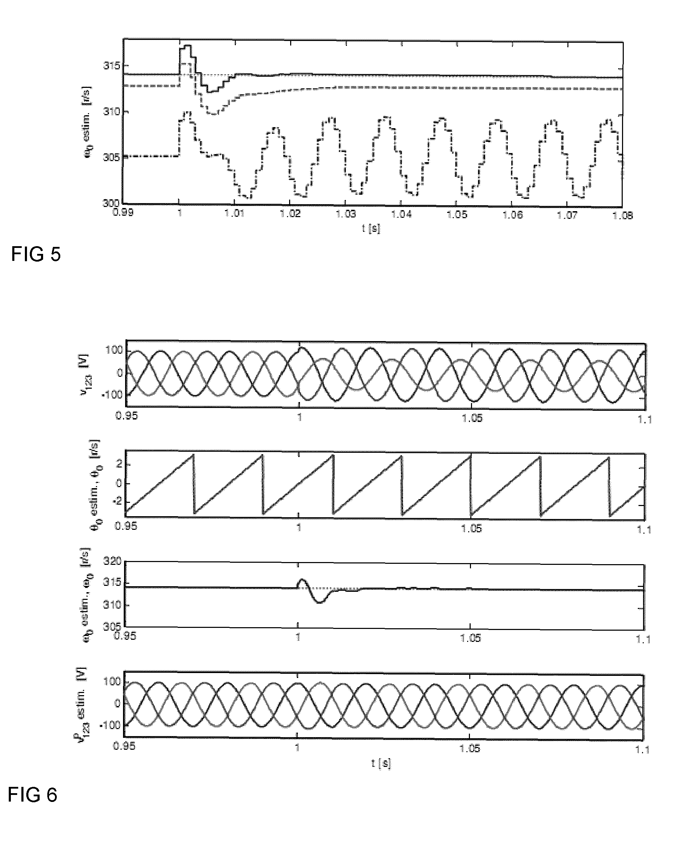

As expected, the steady state error becomes even bigger for a lower sampling frequency. For instance, Figure 5 shows that for a sampling frequency of 1 kHz the improved discretization of UH-PLL now stabilizes at 312.87 rad/s, while the regular discretization of UH-PLL stabilizes at 305.117 rad/s before unbalanced operation. The performance of the present invention is shown in solid line, regular discretization of UH-PLL using Euler's backward rule is shown in dash-dot line, and improved discretization of UH-PLL in dashed line.

In the above tests we have not considered harmonic distortion to clearly see steady state errors.

Figure 6 shows a transient response obtained with the proposed dPLL-UH when the reference signal changes from a balanced to an unbalanced operation condition at time $t$=1 s. Figure 6 shows (from top to bottom) the reference signal in three-phase coordinates $v_{123}$, detected phase angle $\hat{\theta}_0$, detected angular frequency $\hat{\omega}_0$, and detected positive-sequence of the fundamental wave component in three-phase coordinates $\hat{V}^{p}_{123,1}$. The sampling frequency is fixed to 4 kHz. Notice that, after a relatively short transient, all signals return to their desired values. For instance, it is observed that the detected phase angle $\hat{\theta}_0$ (solid line) follows perfectly well the true phase angle (dashed line) after an almost imperceptible transient. The detected frequency $\hat{\omega}_0$ (solid line) is also maintained in its reference fixed to 316.14 rad/s (dotted line) after a small transient. Moreover, the detected positive-sequence of the fundamental wave component $\hat{V}^{p}_{123,1}$ has an almost imperceptible variation.

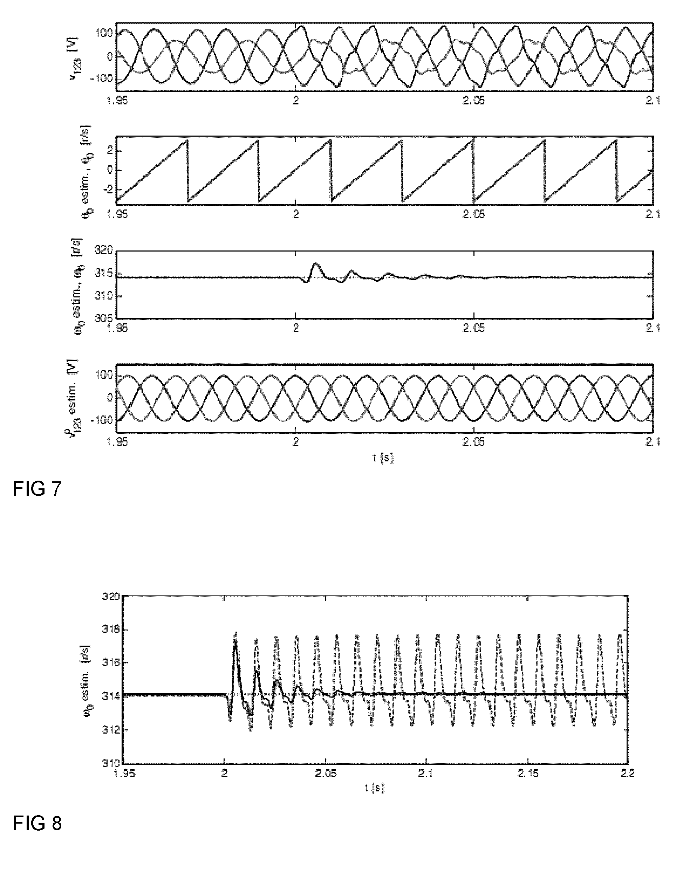

Figure 7 shows a transient response of the proposed dPLL-UH when harmonic distortion is added to the already unbalanced reference signal at t=2 s. Figure 7 shows (from top to bottom) the reference signal in three-phase coordinates $v_{123}$, detected phase angle $\hat{\theta}_0$, detected angular frequency $\hat{\omega}_0$, and detected positive-sequence of the fundamental wave component in three-phase coordinates $\hat{V}^{p}_{123,1}$. The sampling frequency is fixed to 4 kHz. Notice that, after a relatively short transient, all signals return to their desired values. In particular, notice that the detected frequency $\hat{\omega}_0$ (solid line) is also maintained in its reference fixed to 316.14 rad/s (dotted line) after a small transient, without further fluctuations. Moreover, notice that the detected positive-sequence of the fundamental wave component $\hat{V}^{p}_{123,1}$, as well as the detected phase angle $\hat{\theta}_0$, have an almost imperceptible transient.

Figure 8 shows a transient response of the proposed dPLL-UH and dPLL-U when the harmonic distortion is added to an already unbalanced reference signal at t=2 s. Recall that the dPLL-U is a simplified version of the dPLL-UH, which does not include the harmonic compensation mechanism dCM-UH. Notice that, before t=2 s, both methods reach the desired reference, as both are equipped to properly handle unbalance. However, in contrast to the response of the d-PLL-UH, the dPLL-U response has persistent fluctuations after the harmonic distortion is included, that is the dPLL-U is not able to reject this type of disturbances.

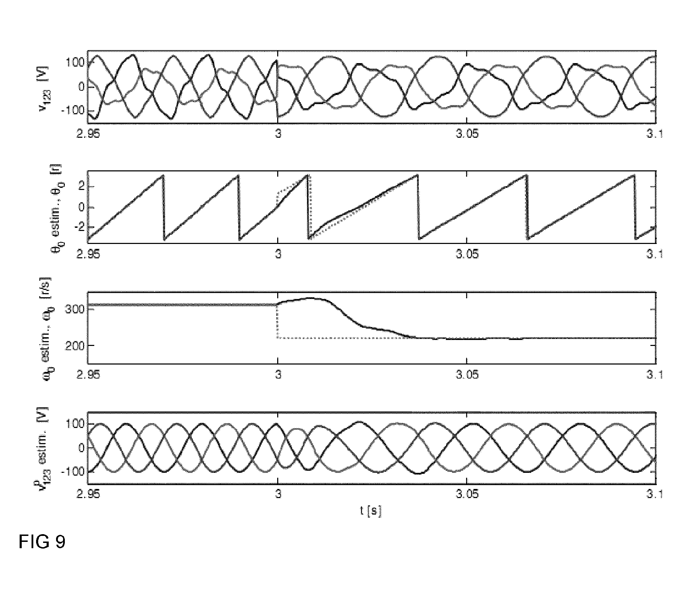

Figure 9 shows a transient response of the proposed dPLL-UH to a step change in the angular frequency of the reference signal changing from 314.16 rad/s (50 Hz) to 219.9 rad/s (35 Hz) at t=3 s. Figure 9 shows (from top to bottom) the reference signal in three-phase coordinates $v_{123}$, detected phase angle $\hat{\theta}_0$, detected angular frequency $\hat{\omega}_0$,

and detected positive-sequence of the fundamental wave component in three-phase coordinates $\hat{V}^{p}_{123,1}$. It is shown that after a short transient, the detected phase angle follows perfectly well the true phase angle. It is shown that the detected fundamental frequency, starting at a reference of 314.16 rad/s (50 Hz) , reaches its new reference fixed to 219.9 rad/s (35 Hz) in a relatively short time. The bottom plot shows that the detected positive sequence signals maintain their amplitude after a relatively short transient.

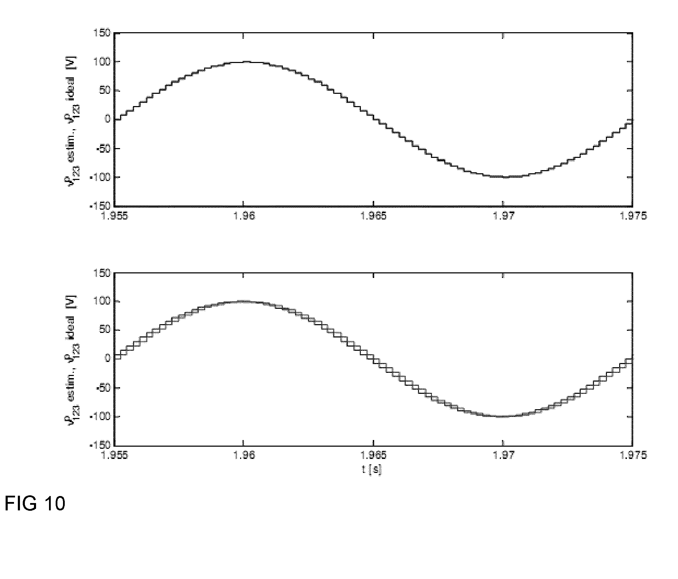

Figure 10 shows a benefit of the compensation mechanism for the implementation delay proposed in (22) to (23). It is observed in the top plot that, with this compensation, both the theoretical sampled positive sequence of the fundamental wave component and its detected value are practically one over the other. However, it is observed in the bottom plot that, without this compensation, a phase shift equivalent to one sampling period arises in between both signals.

Figure 10 only shows coordinate 1 $\hat{V}^{p}_{1,1}$ of the three-phase coordinates and the corresponding sampled theoretical positive-sequence of the fundamental wave component $V^{p}_{1,1}$.

In the above, the invention and its embodiments are described generally relating to a reference voltage the frequency of which is to be detected. It is clear that this reference voltage can be, for example, a measured mains voltage with which a device having the implementation of the invention is to be synchronized.

## References

[1] M.A. Perez, J.R. Espinoza, L.A. Moran, M.A. Torres, and E.A. Araya, "A robust phase-locked loop algorithm to synchronize static-power converters with polluted AC systems," IEEE Trans. on Industrial Electronics, Vol. 55(5), pp. 2185-2192, May 2008.

[2] B.Y. Ren; Y.R. Zhong, X.D. Sun; X.Q. Tong, "A digital PLL control method based on the FIR filter for a grid-connected single-phase power conversion system," in Proc. IEEE International Conference on Industrial Technology ICIT08, 2008, pp. 1-6.

## Claims

1.   A method of detecting a frequency of a measured three-phase voltage, comprising a step of
   measuring the three-phase voltage ($v_{\alpha\beta}$), **characterized by** the steps of
   forming a discrete model for a periodic signal, the discrete model comprising the three-phase voltage ($v_{\alpha\beta}$) and a difference ($\varphi_{\alpha\beta,k}$) between a positive voltage component and a negative voltage component of the three-phase voltage as model variables,
   forming a discrete detector based on the formed discrete model, detecting a fundamental wave component of the voltage ($\hat{v}_{\alpha\beta,1}$) and the difference ($\hat{\varphi}_{\alpha\beta,1}$) between the positive voltage component and the negative voltage component of the three-phase voltage from an error ($\tilde{v}_{\alpha\beta}$) between the measured voltage ($v_{\alpha\beta}$) and the detected fundamental wave component of the voltage ($\hat{v}_{\alpha\beta,1}$) by using the discrete detector and a sampling time *($T_s$)* together with a detected frequency ($\hat{\omega}_0$) of the measured voltage,
   the detected frequency ($\hat{\omega}_0$) of the measured voltage being detected from a detected difference ($\hat{\varphi}_{\alpha\beta,k}$) between positive and negative voltage components of the measured voltage and from the error ($\tilde{v}_{\alpha\beta}$) between the measured voltage ($v_{\alpha\beta}$) and the detected fundamental wave component of the voltage ($\hat{v}_{\alpha\beta,1}$) in an adaptation mechanism.

2.   A method according to claim 1, **characterized by** further comprising calculating a positive sequence component of the fundamental wave component of the voltage from the detected fundamental wave component and the difference, wherein the positive sequence component of the fundamental frequency component has the frequency of the measured three-phase voltage.

3.   A method according to claim 2, **characterized by** further comprising rotating the detected positive sequence component of the fundamental frequency component on the basis of the sampling time and detected frequency for taking into account a delay in the discrete detector.

4.   A method according to any one of the preceding claims 1 to 3, **characterized by** further comprising detecting one or more of harmonic components of a measured voltage signal by using the detected frequency of the measured voltage and the error $\tilde{v}_{\alpha\beta}$) between the measured voltage ($v_{\alpha\beta}$) and the detected fundamental wave component of the voltage ($\hat{v}_{\alpha\beta,1}$).

5. A method according to claims 4, **characterized in that** the detected harmonic components are further removed from the detected fundamental voltage component.

6. An arrangement for detecting the frequency of a measured three-phase voltage, comprising means for measuring the three-phase voltage ($v\alpha\beta$), **characterized in that** the arrangement further comprises
a discrete model for a periodic signal, the discrete model comprising the three-phase voltage ($v_{\alpha\beta}$) and a difference ($\varphi_{\alpha\beta,k}$) between a positive voltage component and a negative voltage component of the three-phase voltage as model variables,
a discrete detector based on the formed discrete model,
means for detecting a fundamental wave component of the voltage ($\hat{v}_{\alpha\beta,1}$) and the difference ($\hat{\varphi}_{\alpha\beta,1}$) between the positive voltage component and the negative voltage component of the three-phase voltage from an error ($\tilde{v}_{\alpha\beta}$) between the measured voltage ($v\alpha\beta$) and the detected fundamental wave component of the voltage ($\hat{v}_{\alpha\beta,1}$) by using the discrete detector and a sampling time ($T_s$) together with a detected frequency ($\hat{\omega}_0$) of the measured voltage, the detected frequency ($\hat{\omega}_0$) of the measured voltage being detected from a detected difference ($\hat{\varphi}_{\alpha\beta,k}$) between positive and negative voltage components of the measured voltage and from the error ($\tilde{v}_{\alpha\beta}$) between the measured voltage ($v_{\alpha\varphi}$) and the detected fundamental wave component of the voltage ($\hat{v}_{\alpha\beta,1}$) in an adaptation mechanism.

EP 2 590 328 A1

FIG 1

FIG 2

FIG 3

FIG 4

FIG 5

FIG 6

FIG 7

FIG 8

FIG 9

FIG 10

Europäisches
Patentamt

European
Patent Office

Office européen
des brevets

# EUROPEAN SEARCH REPORT

Application Number

EP 11 18 7366

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 2 372 376 A1 (ABB RESEARCH LTD [CH]) 5 October 2011 (2011-10-05) * the whole document * | 1-6 | INV. H03L7/08 G01R19/25 |
| Y | US 2009/105979 A1 (ESCOBAR VALDERRAMA GERARDO [MX] ET AL) 23 April 2009 (2009-04-23) * the whole document * | 1-6 | |
| Y | VIKRAM KAURA ET AL: "Operation of a Phase Locked Loop System Under Distorted Utility Conditions", IEEE TRANSACTIONS ON INDUSTRY APPLICATIONS, IEEE SERVICE CENTER, PISCATAWAY, NJ, US, vol. 33, no. 1, 1 February 1997 (1997-02-01), XP011022136, ISSN: 0093-9994 * page 58 - page 59 * | 1-6 | |
| A | BI-YING REN ET AL: "A digital PLL control method based on the FIR filter for a grid-connected single-phase power conversion system", INDUSTRIAL TECHNOLOGY, 2008. ICIT 2008. IEEE INTERNATIONAL CONFERENCE ON, IEEE, PISCATAWAY, NJ, USA, 21 April 2008 (2008-04-21), pages 1-6, XP031313809, ISBN: 978-1-4244-1705-6 * the whole document * | 1-6 | TECHNICAL FIELDS SEARCHED (IPC) H03L G01R |

-/--

The present search report has been drawn up for all claims

| Place of search | Date of completion of the search | Examiner |
|---|---|---|
| Munich | 7 March 2012 | Kahn, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt

European Patent Office

Office européen des brevets

## EUROPEAN SEARCH REPORT

Application Number

EP 11 18 7366

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MARCELO A PEREZ ET AL: "A Robust Phase-Locked Loop Algorithm to Synchronize Static-Power Converters With Polluted AC Systems", IEEE TRANSACTIONS ON INDUSTRIAL ELECTRONICS, IEEE SERVICE CENTER, PISCATAWAY, NJ, USA, vol. 55, no. 5, 1 May 2008 (2008-05-01), pages 2185-2192, XP011204616, ISSN: 0278-0046 * the whole document * | 1-6 | |
| A | PEDRO RODRIGUEZ ET AL: "Decoupled Double Synchronous Reference Frame PLL for Power Converters Control", IEEE TRANSACTIONS ON POWER ELECTRONICS, IEEE SERVICE CENTER, PISCATAWAY, NJ, US, vol. 22, no. 2, 1 March 2007 (2007-03-01), pages 584-592, XP011172382, ISSN: 0885-8993, DOI: 10.1109/TPEL.2006.890000 * the whole document * | 1-6 | TECHNICAL FIELDS SEARCHED (IPC) |

The present search report has been drawn up for all claims

| Place of search | Date of completion of the search | Examiner |
|---|---|---|
| Munich | 7 March 2012 | Kahn, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 18 7366

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2012

| Patent document cited in search report | | Publication date | Patent family member(s) | | Publication date |
|---|---|---|---|---|---|
| EP 2372376 | A1 | 05-10-2011 | CN | 102207521 A | 05-10-2011 |
| | | | EP | 2372376 A1 | 05-10-2011 |
| | | | US | 2011241652 A1 | 06-10-2011 |
| US 2009105979 | A1 | 23-04-2009 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M.A. PEREZ ; J.R. ESPINOZA ; L.A. MORAN ; M.A. TORRES ; E.A. ARAYA.** A robust phase-locked loop algorithm to synchronize static-power converters with polluted AC systems. *IEEE Trans. on Industrial Electronics,* May 2008, vol. 55 (5), 2185-2192

- **B.Y. REN ; Y.R. ZHONG ; X.D. SUN ; X.Q. TONG.** A digital PLL control method based on the FIR filter for a grid-connected single-phase power conversion system. *Proc. IEEE International Conference on Industrial Technology ICIT08,* 2008, 1-6